# FASCICULE DE BREVET EUROPEEN

(11) **EP 1 704 607 B1**
(45) Date de publication et mention de la délivrance du brevet: **29.08.2018**
(21) Numéro de dépôt: 04805834.1
(22) Date de dépôt: 16.11.2004
(51) Int. Cl.: H01L 51/46, H01L 51/48, H01G 9/20, H01L 31/107

(54) **MATERIAU HYBRIDE INORGANIQUE-ORGANIQUE SEMI-CONDUCTEUR P-N, SON PROCEDE DE FABRICATION ET CELLULE PHOTOVOLTAIQUE COMPRENANT LEDIT MATERIAU**
P-N-HYBRIDMATERIAL FÜR EINEN ANORGANISCHEN/ORGANISCHEN HALBLEITER, HERSTELLUNGSVERFAHREN DAFÜR UND FOTOVOLTAIKZELLE DAMIT
INORGANIC/ORGANIC SEMICONDUCTOR P-N HYBRID MATERIAL, PRODUCTION METHOD THEREOF AND PHOTOVOLTAIC CELL COMPRISING SAME

(30) Priorité: 17.11.2003 FR 0350841
(43) Date de publication de la demande: 27.09.2006
(73) Titulaire: Commissariat à l'Énergie Atomique et aux Énergies Alternatives, 75015 Paris (FR)
(72) Inventeur: BELLEVILLE, Philippe, F-37000 TOURS (FR); SANCHEZ, Clément, F-91440 BURES SUR YVETTE (FR); BUVAT, Pierrick, F-37250 MONTBAZON (FR); PRENE, Philippe, F-37200 TOURS (FR)
(74) Mandataire: Ahner, Philippe
(86) Numéro de dépôt international: PCT/FR2004/050591
(87) Numéro de publication internationale: WO 2005/050752

(56) Documents cités:
- EP-A- 0 917 208
- EP-A- 1 176 646
- DE-A- 19 927 981
- US-A1- 2002 084 504
- GAPONENKO N V ET AL: "Terbium photoluminescence in polysiloxane films" 24 avril 2001 (2001-04-24), MATERIALS SCIENCE AND ENGINEERING B, ELSEVIER SEQUOIA, LAUSANNE, CH, PAGE(S) 191-193 , XP004234646 ISSN: 0921-5107 Paragraphe: 2 EXPERIMENTAL DETAILS
- DING H ET AL: "NANOFABRICATION OF ORGANIC/INORGANIC HYBRIDS OF TIO2 WITH SUBSTITUTED PHTHALOCYANINE OF POLYTHIOPHENE" JOURNAL OF NANOSCIENCE AND NANOTECHNOLOGY, AMERICAN SCIENTIFIC PUBLISHERS, US, vol. 1, no. 2, juin 2001 (2001-06), pages 207-213, XP008033252 ISSN: 1533-4880

## Description

### DOMAINE TECHNIQUE

La présente invention se rapporte à un matériau hybride inorganique-organique semi-conducteur P-N destiné à entrer dans la constitution d'une cellule photo-électrochimique, plus particulièrement d'une cellule photovoltaïque.

La présente invention a également trait à un procédé de fabrication d'un tel matériau et à une cellule photovoltaïque comprenant ledit matériau.

Le domaine général de l'invention est donc celui des cellules photo-électrochimiques, plus particulièrement des cellules photovoltaïques ou encore des diodes électroluminescentes.

### ETAT DE LA TECHNIQUE ANTERIEURE

Une cellule photovoltaïque est un dispositif permettant la conversion d'une énergie photochimique en énergie électrique.

Généralement, une cellule photovoltaïque se compose de matériaux semi-conducteurs dopés P (c'est-à-dire présentant un déficit d'électrons, c'est-à-dire des trous de charges) et de matériaux semi-conducteurs dopés N (c'est-à-dire présentant un excès d'électrons), réunis par une jonction dite « jonction P-N », qui permet une séparation entre les électrons et les trous de charge. Cette séparation génère une différence de potentiel à la jonction P-N et par conséquent un courant électrique si l'on place un contact sur la zone N et un contact sur la zone P et une résistance (à savoir un dispositif destiné à être alimenté en courant électrique) entre ces deux contacts.

Ainsi, lorsque la lumière frappe la zone de la cellule constituée de la jonction entre le matériau semi-conducteur de type P et le matériau semi-conducteur de type N, les photons constitutifs de la lumière sont absorbés par ladite zone et chaque photon absorbé donne naissance à un électron et un trou (on parle de paire électron-trou), ladite paire étant séparée à la jonction du matériau de type N et du matériau du type P, créant ainsi une différence de potentiel de part et d'autre de cette jonction.

Jusqu'à récemment, la plupart des cellules photovoltaïques ont été fabriquées à partir de silicium, plus précisément de silicium dopé par des atomes tels que du phosphore pour constituer la zone N et de silicium dopé par des atomes tels que du bore pour constituer la zone P de la cellule. Toutefois, l'utilisation du silicium s'avère coûteuse.

Pour remédier à cet inconvénient, la recherche s'est attachée à développer de nouveaux matériaux pouvant entrer dans la constitution de cellules photovoltaïques.

Ainsi, des cellules photovoltaïques ont été conçues à partir d'un matériau semi-conducteur de type P-N comprenant une zone semi-conductrice N solide et une zone semi-conductrice P liquide. Plus précisément, la zone semi-conductrice N est constituée d'une céramique oxyde poreuse, par exemple du dioxyde de titane dont les pores sont remplis d'un électrolyte liquide conducteurs de charges, cet électrolyte remplissant le rôle de zone semi-conductrice P.

Ce type de cellule photovoltaïque est notamment décrit dans la demande internationale de brevet WO 93/19479 [1].

Toutefois, il a été constaté que les cellules photovoltaïques utilisant un électrolyte liquide présentent les inconvénients suivants :
- une faible stabilité dans le temps, liée à l'évaporation des solvants entrant dans la composition de l'électrolyte ;
- une plage de température de fonctionnement relativement limitée en raison du caractère volatil des solvants entrant dans la constitution de l'électrolyte ;
- un risque de précipitation des sels entrant dans la constitution de l'électrolyte, lorsque la cellule photovoltaïque est amenée à fonctionner à des températures très basses, telles que des températures de l'ordre de -10°C à -40°C.
- une mise en oeuvre contraignante du fait de l'utilisation d'un électrolyte liquide, excluant notamment l'emploi de supports organiques souples et/ou de grandes dimensions.

Pour remédier à cela, les travaux de recherche se sont focalisés sur la conception de cellules photovoltaïques comprenant des matériaux semi-conducteurs P-N, comprenant à la fois une zone semi-conductrice N solide et une zone semi-conductrice P solide.

Ainsi, la demande de brevet EP 1176646 [2] décrit des cellules photovoltaïques comprenant une zone semi-conductrice N constituée d'une céramique oxyde de titane sensibilisée par des nanoparticules de semi-conducteur inorganique et comprenant une zone semi-conductrice P constituée par une molécule organique conducteur de trous appartenant à la famille des composés spiro- et hétérospiro, en particulier le polymère 2,2',7,7'-tétrakis(N,N-di-p-méthoxyphényl-amine)9,9'-spirobifluorène (connu sous l'abréviation OMeTAD). Cette zone P est obtenue par enduction centrifuge (ou « spin coating » selon la terminologie anglo-saxonne) de la zone N avec une solution comprenant l'OMeTAD et du chlorobenzène. Toutefois, le temps de contact entre la solution contenant de l'OMeTAD et la couche en oxyde de titane est relativement court du fait de l'évaporation rapide du chlorobenzène et de la méthode de dépôt utilisée. Ceci se traduit notamment par une interpénétration limitée des zones N et P, cette interpénétration limitée étant également due à la diffusion lente des molécules d'OMeTAD vers la surface interne de la céramique (à savoir la surface de paroi des pores). Cette interpénétration limitée des zones N et P se traduit par un rendement solaire très faible.

De plus, l'interaction entre la zone N constituée d'une céramique oxyde et la zone P constituée par le polymère conducteur de charges susmentionné est une interaction faible, du fait que le polymère conducteur se lie à la céramique par adsorption, plus particulièrement par le biais d'interactions faibles de type Van der Waals.

La demande de brevet EP 0 917 208 [3] décrit une cellule photovoltaïque comprenant un film photoactif constitué d'une matrice de polymère organique à base de polyparaphénylènevinylène (connu sous l'abréviation PPV) dans laquelle sont dispersées des nanoparticules de type semi-conducteur (en particulier TiO₂). Dans cette configuration, le PPV assure la fonction de conducteurs de trous (c'est-à-dire la fonction d'une zone semi-conductrice P) et la fonction d'une substance chromophore en absorbant les photons issus de la lumière tandis que les nanoparticules dispersées assurent le rôle de conducteur d'électrons (zone semi-conductrice N). Cependant, ce type de configuration présente les inconvénients suivants :
- la dispersion de nanoparticules dans la matrice organique limite la percolation de celles-ci et ainsi la conduction des électrons vers la couche collectrice d'électrons de la cellule photovoltaïque ;
- la dispersion de nanoparticules dans la matrice organique induit un fort taux de recombinaison électron-trou à l'interface PPV/nanoparticules.

La demande de brevet WO 93/20569 [4] décrit une cellule photovoltaïque à colorant, comprenant une zone constituée par un film poreux d'oxyde de titane sensibilisé par une substance chromophore et une zone constituée d'un polymère conducteur de trous. Le procédé de fabrication de ce type de cellule photovoltaïque consiste à déposer à haute température (de l'ordre de 300°C) le polymère conducteur à l'état fondu sur le film poreux d'oxyde de titane. Toutefois, le matériau obtenu présente les inconvénients suivants:
- il se caractérise par une interpénétration entre le film poreux et le polymère limitée par la diffusion du polymère à l'état fondu dans la porosité du film d'oxyde de titane ;
- il comprend une jonction lâche entre le matériau semi-conducteur N et le matériau semi-conducteur P du fait que la liaison entre ces deux zones se fait par adsorption, plus particulièrement par des interactions faibles de type Van der Waals ;
- l'opération réalisée à haute température (de l'ordre de 200 à 300°C) peut endommager la substance chromophore et empécher l'utilisation d'une large gamme de substances chromophores aux températures de décomposition basses.

Ainsi, il ressort des réalisations de l'art antérieur l'un ou plusieurs des inconvénients suivants limitant les performances :
- une interpénétration limitée de la zone semi-conductrice N et de la zone semi-conductrice P ;
- un fort taux de recombinaison électron-trou à la jonction de ces zones du fait de la faible interpénétration des différents composants zone N/chromophore/zone P ;
- une faible jonction entre la zone P et la zone N du fait du caractère faible des liaisons participant à ladite jonction.

Les inventeurs se sont donc fixé pour objectif de fournir un matériau semi-conducteur de type P-N qui soit exempt des inconvénients mentionnés ci-dessus, notamment en ce qu'il présente une interaction forte entre la zone semi-conductrice P et la zone semi-conductrice N, et qui permet toutefois de limiter les phénomènes de court-circuit entre ces deux zones.

Ces buts sont atteints par la présente invention qui propose notamment un matériau hybride inorganique-organique semi-conducteur de type P-N.

la demande de brevet DE19927981 décrit l'imprégnation d'un substrat poreux avec une solution de monomère suivie d'une étape de polymérisation.

### EXPOSÉ DE L'INVENTION

Ainsi, l'invention a trait, selon un premier objet, à un matériau semi-conducteur P-N susceptible d'être obtenu par un procédé comprenant successivement les étapes suivantes :
- une étape de fonctionnalisation d'un substrat en céramique oxyde poreuse (sensibilisée ou non par une ou plusieurs substances chromophores, qui est un substrat en TiO₂, par greffage chimique d'un ou plusieurs composés comprenant au moins un groupe susceptible d'être polymérisé avec un ou plusieurs précurseurs d'un polymère conducteur de l'électricité, le ou lesdits précurseurs étant un alkylthiophène, et comprenant au moins un groupe apte à se greffer chimiquement audit substrat, ledit composé répondant à la formule : 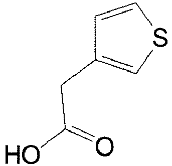
- une étape d'imprégnation dudit substrat ainsi fontionnalisé par une solution comprenant le ou lesdits précurseur(s) ;
- une étape de polymérisation du ou desdits précurseurs.

Avant d'entrer plus en détails dans la description, nous proposons les définitions suivantes.

Par matériau semi-conducteur P-N, one entend un matériau comprenant à la fois une zone semi-conductrice de type N et une zone semi-conductrice de type P. Dans le cadre de l'invention, la zone semi-conductrice de type N peut être constituée par le substrat susmentionné, auquel cas la zone conductrice de type P sera constituée par le ou les polymères conducteurs de l'électricité résultant de l'étape de polymérisation. Inversement, la zone conductrice de type N peut être constituée par le ou les polymères conducteurs de l'électricité résultant de l'étape de polymérisation, auquel cas la zone semi-conductrice de type P est constituée par le substrat en céramique poreuse. On précise également que ce matériau peut se présenter sous forme d'un bloc (ou d'une pièce) ou encore sous forme d'un revêtement (par exemple d'un film présentant une épaisseur de 10 nm à 100 µm).

Par polymère conducteur de l'électricité, on entend généralement un polymère présentant des propriétés de conduction électrique sans dopage (auquel cas le polymère sera un polymère conducteur intrinsèque de l'électricité) ou avec dopage (auquel cas le polymère sera un polymère conducteur extrinsèque de l'électricité), la conduction électrique étant véhiculée soit par le biais d'électrons (en ce qui concerne les polymères conducteurs de type N), soit par le biais de trous, qui correspondent à des 'espaces' laissés vacants par des électrons (en ce qui concerne les polymères conducteurs de type P). Des exemples spécifiques de ces différents types de polymères seront donnés ultérieurement.

Par greffage chimique, on entend, dans ce qui précède et ce qui suit, une immobilisation du ou des composés sus-mentionnés sur le substrat susmentionné par le biais d'une liaison chimique covalente, voire iono-covalente grâce à la présence sur le ou les composés de l'étape de fonctionnalisation d'un ou plusieurs groupes aptes à se greffer au substrat. On précise que cette immobilisation se fait à la fois à la surface externe du substrat et également à la surface interne dudit substrat, c'est-à-dire sur la surface de parois des pores du sustrat.

Par groupe apte à se greffer chimiquement audit substrat, on entend généralement des groupes aptes à réagir avec les groupes réactifs présents sur la céramique oxyde pour donner une liaison covalente ou iono-covalente. Les groupes réactifs du substrat peuvent être des groupes -OH, ces groupes -OH résultant d'un phénomène d'hydratation spontanée de la céramique, soit sous l'effet de l'humidité de l'atmosphère ambiante, soit sous l'effet d'une humidité provoquée pour créer ces groupes.

Par précurseur de polymère conducteur de l'électricité, on entend généralement des monomères, éventuellement des oligomères (assemblage de 2 ou plusieurs dizaines d'entités monomères) dont la polymérisation conduit à des polymères conducteurs de l'électricité.

Ainsi, contrairement aux réalisations de l'art antérieur, le matériau semi-conducteur P-N présente une jonction entre la zone semi-conductrice P et la zone semi-conductrice N résultant d'un greffage chimique.

De ce fait, les matériaux de l'invention présentent une jonction améliorée par rapport aux matériaux de l'art antérieur entre la surface du substrat en céramique oxyde et le ou les polymères résultant de l'étape de polymérisation du ou desdits précurseurs mentionnés ci-dessus.

De plus, les matériaux de l'invention présentent une amélioration de l'interpénétration des polymères dans la céramique. Ceci est due au fait que les matériaux de l'invention sont obtenus par un procédé mettant en oeuvre une étape d'imprégnation d'un substrat en céramique oxyde poreuse avec des précurseurs de polymère et non des polymères en soi, ce qui permet une amélioration de l'interpénétration dans la céramique poreuse des espèces s'infiltrant en raison de la taille des précurseurs inférieures à la taille des polymères utilisés dans l'art antérieur.

Ainsi, les matériaux de l'invention présentent à la fois une meilleure jonction entre la surface du substrat en céramique oxyde et le ou les polymères et une meilleure interpénétration de ceux-ci dans la céramique poreuse et donc une meilleure interpénétration des zones N et P susmentionnées.

Le ou les groupes aptes à se greffer chimiquement à la céramique ainsi un groupe de formule
- COOR¹ avec R¹ représentant un atome d'hydrogène.

Le greffage chimique avec le substrat en céramique oxyde poreuse se fait par les groupes mentionnés précédemment. On précise que le ou les groupes aptes à se polymériser et les groupes susmentionnés sont liés directement par le biais par le biais d'un groupe alkylène comprenant 1 atomes de carbone.

Le ou les groupes susceptibles d'être polymérisés avec un ou plusieurs précurseurs d'un polymère conducteur de l'électricité correspondent à un groupe thiophène.

Ainsi, le composé utilisé dans l'étape de fonctionnalisation avec notamment un substrat en dioxyde de titane comprend à la fois un groupe apte à se greffer chimiquement au substrat (ce groupe étant -COOH) et un groupe apte à se polymériser avec un précurseur de polymère conducteur de l'électricité (ce groupe étant un groupe thiophène), ce composé répondant à la formule suivante :

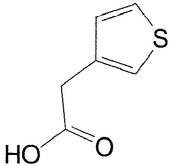

Comme cela a été mentionné précédemment, le substrat
en céramique oxyde poreuse utilisée selon l'invention est du dioxyde de titane TiO₂.

Selon l'invention, la surface ainsi que l'intérieur du substrat en céramique poreuse est greffé, à l'issue du procédé, par un ou plusieurs polymères conducteurs de l'électricité obtenus par polymérisation du ou desdits précurseurs, le ou lesdits précurseurs étant un alkylthiophène.

Enfin, ledit matériau peut comprendre en outre une ou plusieurs substances chromophores sensibilisant ladite céramique. On précise que, selon la nature de la substance chromophore, celle-ci peut être soit adsorbée soit greffée chimiquement à la surface et à l'intérieur du substrat en céramique oxyde.

On précise que, selon l'invention, on entend généralement par substance chromophore une substance apte à absorber une lumière dans le domaine IR, UV et visible et à libérer en contrepartie de cette absorption des électrons. Dans le cadre de l'invention, les électrons vont être captés soit par la céramique oxyde (si celle-ci est semi-conductrice N) soit par le ou les polymères conducteurs de l'électricité (si ceux-ci sont des polymères de type N), tandis que les trous de charges laissés par les électrons libérés sont captés soit par la céramique oxyde (si celle-ci est semi-conductrice de type P) soit par le ou les polymères conducteurs de l'électricité (si ceux-ci sont des polymères de type P).

Il est entendu qu'une substance chromophore donnée présente une sensibilité spectrale bien déterminée et que le choix de cette substance devra être adaptée à la source de lumière, afin de présenter un rendement d'absorption de lumière aussi performant que possible.

L'invention a également trait, selon un second objet, à un procédé de préparation d'un matériau semi-conducteur tel que défini précédemment comprenant successivement les étapes suivantes :
- une étape de fonctionnalisation d'un substrat en céramique oxyde poreuse (sensibilisée ou non par une ou plusieurs substances chromophores), qui est un substrat en TiO₂, par greffage chimique d'un ou plusieurs composés comprenant au moins un groupe susceptible d'être polymérisé avec un ou plusieurs précurseurs d'un polymère conducteur de l'électricité, le ou lesdits précurseurs étant un alkylthiophène et comprenant au moins un groupe apte à se greffer chimiquement audit substrat, ledit composé répondant à la formule : 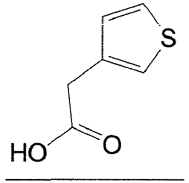
- une étape d'imprégnation dudit substrat ainsi fontionnalisé par une solution comprenant le ou lesdits précurseur(s) ;
- une étape de polymérisation du ou desdits précurseurs.

Ainsi, le procédé de l'invention permet, grâce à l'étape de fonctionnalisation de la céramique oxyde poreuse par un ou des composés mentionnés ci-dessus, d'améliorer la jonction entre la surface du substrat en céramique oxyde et le ou les polymères résultant de l'étape de polymérisation du ou desdits précurseurs mentionnés ci-dessus.

Le procédé de l'invention met en oeuvre, comme certains procédés de l'art antérieur, une étape d'imprégnation d'un substrat en céramique oxyde poreuse mais, contrairement à l'art antérieur, l'imprégnation selon l'invention se fait avec des précurseurs de polymère et non des polymères en soi, ce qui permet une amélioration de l'interpénétration dans la céramique poreuse des espèces s'infiltrant en raison de la taille des précurseurs inférieures à la taille des polymères utilisés dans l'art antérieur.

Grâce aux deux étapes susmentionnées, le procédé de l'invention permet à la fois une meilleure jonction entre la surface du substrat en céramique oxyde et le ou les polymères et une meilleure interpénétration de ceux-ci dans la céramique poreuse et donc une meilleure interpénétration des zones N et P susmentionnées.

Comme mentionné précédemment, le procédé selon l'invention comprend, en premier lieu, une étape de fonctionnalisation de la surface d'un substrat en céramique oxyde poreuse par mise en contact dudit substrat avec un ou plusieurs composés tels que définis précédemment.

Au sens de la présente invention, on entend par « céramique oxyde poreuse » une céramique telle que définie précédemment. Le ou les composés comprenant un groupe apte à être polymérisé avec un ou plusieurs précurseurs d'un polymère conducteur de l'électricité, sont des composés aptes à se greffer chimiquement à la surface de la céramique oxyde susmentionnée. Ils sont tels que définis précédemment.

Des groupes susceptibles de se polymériser sont des groupes thiophène. Pour ces groupes, les précurseurs aptes à polymériser avec eux sont des composés alkylthiophènes.

Les groupes aptes à se greffer chimiquement à la surface d'une céramique oxyde et les groupes susceptibles de se polymériser lors d'une réaction d'une polymérisation sont séparés par un groupe espaceur, qui est un groupe alkylène comportant 1 atome de carbone. La présence d'un tel groupe espaceur peut permettre de régler la distance vis-à-vis d'une ou plusieurs substances chromophores, si celles-ci sont présentes.

Comme il est précisé plus haut, une surface en céramique est fonctionnalisée par des composés tel que définis précédemment, lesdits composés se greffant chimiquement à ladite surface.

Pour obtenir une telle fonctionnalisation, différentes techniques peuvent être envisagées, en particulier des techniques par voie liquide, c'est-à-dire par imprégnation du substrat susmentionné avec une solution comprenant le ou les composés tels que définis ci-dessus.

Ainsi, la fonctionnalisation par greffage chimique de la surface et de l'intérieur de la céramique oxyde poreuse peut s'effectuer par l'une des techniques suivantes :
- le trempage-retrait (connu sous la terminologie anglaise « dip-coating ») ;
- l'enduction centrifuge (connu sous la terminologie anglaise « spin-coating ») ;
- l'enduction laminaire (connu sous la terminologie anglaise « laminar-flow-coating ») ;
- la pulvérisation (connu sous la terminologie anglaise « spray-coating »)
- l'épandage (connu sous la terminologie anglaise « soak coating ») ;
- l'enduction au rouleau (connu sous la terminologie « roll to roll process ») ;
- l'enduction au pinceau (connu sous la terminologie anglaise « painting coating ») ;
- la sérigraphie (connu sous la terminologie anglaise « screen printing »).

Ces différentes techniques doivent être mises en oeuvre avantageusement pendant un temps approprié, de manière à permettre un contact optimum du substrat en céramique oxyde poreuse avec la solution comprenant le ou les composés aptes à être greffés, de façon à ce que le substrat soit imprégné à la fois à sa surface et en son intérieur et à ce que les composés puissent réagir et se lier chimiquement à la surface et à l'intérieur dudit substrat.

On précise que la solution peut comprendre également une ou plusieurs substances chromophores, auquel cas l'étape de fonctionnalisation s'accompagnera d'une sensibilisation du substrat en céramique oxyde par la ou lesdites substances chromophores.

Le procédé de l'invention peut comprendre également en alternative une étape d'imprégnation dudit substrat, avant l'étape de fonctionnalisation ou après celle-ci, par une solution comprenant une ou plusieurs substances chromophores de manière à sensibiliser ledit substrat.

La ou les substances chromophores envisageables sont les mêmes que celles mentionnées ci-dessus.

Le composé utilisé dans l'étape de fonctionnalisation est le composé répondant à la formule suivante :

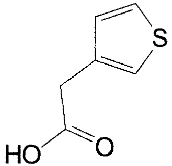

Ce composé comprend un groupe -CO₂H apte à se greffer chimiquement à la surface d'une substrat en céramique oxyde, tel que TiO₂, et un groupe thiophène apte à se polymériser avec un ou plusieurs précurseurs de polymère conducteur de l'électricité, le ou lesdits précurseurs étant un alkylthiophène.

Après cette étape de fonctionnalisation, le procédé de l'invention peut comprendre une étape de traitement destiné à éliminer les résidus de la réaction de greffage ainsi que les espèces n'ayant pas réagi.

On précise que le greffage ou l'adsorption de substances chromophores, le cas échéant, pourra se faire par les mêmes voies que la fonctionnalisation par des composés tels que définis précédemment, voire même simultanément à celle-ci.

Une fois l'étape de fonctionnalisation achevée, le procédé de l'invention prévoit une étape d'imprégnation du substrat ainsi fonctionnalisé par un ou plusieurs précurseurs tels que définis précédemment.

Concrètement, cette étape consiste généralement à imprégner le substrat ainsi fonctionnalisé par une solution organique comprenant le ou lesdits précurseurs.

L'imprégnation par un ou plusieurs précurseurs de polymères conducteurs de l'électricité se fait par voie liquide, plus précisément par une des techniques mentionnées ci-dessus :
- le trempage-retrait (connu sous la terminologie anglaise « dip-coating ») ;
- l'enduction centrifuge (connu sous la terminologie anglaise « spin-coating ») ;
- l'enduction laminaire (connu sous la terminologie anglaise « laminar-flow-coating ») ;
- la pulvérisation (connu sous la terminologie anglaise « spray-coating »)
- l'épandage (connu sous la terminologie anglaise « soak coating ») ;
- l'enduction au rouleau (connu sous la terminologie « roll to roll process ») ;
- l'enduction au pinceau (connu sous la terminologie anglaise « painting coating »)
- la sérigraphie (connu sous la terminologie anglaise « screen printing »).

Ces techniques doivent être mises en oeuvre pendant un temps adéquat de manière à imprégner à la fois la surface du substrat en céramique oxyde et les pores de celles-ci.

Une fois l'étape d'imprégnation achevée, il est alors possible de démarrer l'étape de polymérisation. Cette étape consiste à faire croître, par polymérisation des précurseurs, des chaînes polyméres à partir des groupes susceptibles d'être polymérisés présents sur le ou les composés de l'étape de fonctionnalisation.

Cette étape de polymérisation peut démarrer par ajout dans la solution susmentionnée d'un amorceur de polymérisation, lorsque la polymérisation envisagée est une polymérisation chimique.

Par amorceur de polymérisation, on entend un réactif apte à déclencher la réaction de polymérisation entre les composés greffés lors de l'étape de fonctionnalisation et le ou les précurseurs susmentionnés. Concrètement, cet amorceur va créer des centres réactifs, à l'origine de la propagation de la réaction de polymérisation. Le choix de l'amorceur sera aisément réalisé par l'homme de l'art en fonction du polymère à synthétiser. En particulier, cet amorceur pourra être un oxydant (exemple : le trichlorure de fer FeCl₃) pour polymériser par oxydation chimique des composés de la famille des polythiophènes.

Il est également possible d'envisager, selon l'invention, une polymérisation électrochimique des précurseurs de l'invention. Dans ce cas, l'on fait passer un courant à travers le substrat imprégné de la solution comprenant le ou lesdits précurseurs, ledit courant déclenchant la polymérisation du ou desdits précurseurs.

Une fois l'étape de polymérisation achevée, le procédé de l'invention peut comprendre une étape de traitement destiné à éliminer le ou les solvants présents dans la solution d'imprégnation, les résidus de réaction et les précurseurs n'ayant pas réagi.

Le procédé selon l'invention présente de nombreux avantages. En effet :
- il permet une bonne interpénétration entre la zone constituée de la céramique oxyde poreuse et les polymères conducteurs électriques greffés à la surface de cette zone ;
- il met en oeuvre des techniques simples, réalisables à température ambiante.

Les matériaux semi-conducteurs de l'invention peuvent être utilisés dans différents dispositifs nécessitant la présence d'un matériau semi-conducteur tels que des dispositifs électrochimiques, des dispositifs photo-électrochimiques et des dispositifs de catalyse et en particulier dans des cellules photovoltaïques ou les diodes électroluminescentes.

Ainsi, la présente invention a également pour objet une cellule photovoltaïque comprenant :
- une première électrode collectrice de courant (dite « électrode de travail ») ;
- une seconde électrode (dite « contre-électrode de travail ») ;
- une zone semi-conductrice constituée du matériau semi-conducteur tel que défini précédemment, ladite zone étant disposée entre ladite première électrode et ladite seconde électrode.

La première électrode, ou électrode de travail comprend une partie conductrice sous forme, par exemple, d'une couche d'oxyde d'étain dopé au fluor, cette partie pouvant être déposée sur un support.

On précise que par support, on entend généralement, au sens de l'invention, tout substrat, organique ou inorganique, se caractérisant par une transparence au moins égale à 50% dans le spectre solaire. Ce support peut être par exemple en verre transparent.

Il est noté que la partie conductrice susmentionnée sera en contact avec la zone semi-conductrice susmentionnée, soit de manière directe, soit par le biais d'une couche de dioxyde de titane dense, cette dernière permettant d'éviter un contact direct entre l'électrode de travail et la zone semi-conductrice et de ce fait un court-circuit dans la cellule photovoltaïque.

Il est précisé également qu'une couche à base de polymère conducteur de l'électricité peut être interposée entre ladite zone semi-conductrice et la seconde électrode (dite « contre-électrode de travail »), de manière à éviter un court-circuit dans la cellule photovoltaïque.

Généralement, la seconde électrode (ou « contre-électrode de travail ») se présente sous la forme d'une couche métallique, par exemple une couche métallique à base d'or et/ou de nickel.

Les cellules photovoltaïques conçues à partir du matériau hybride inorganique-organique semi-conducteur P-N de l'invention présentent les avantages suivants :
- le fait de greffer des polymères conducteurs de l'électricité via des composés tels que définis précédemment sur et dans la céramique oxyde poreuse favorise le transfert des charges au moment de la dissociation électron-trou entre la céramique, les polymères conducteurs et éventuellement le ou les substances chromophores ;
- le fait d'utiliser un matériau semi-conducteur conforme à l'invention présentant une excellente interpénétration des zones N et des zones P confère une efficacité de ladite électrode photo-active dans toute son épaisseur et fournit ainsi une configuration favorable pour améliorer le rendement solaire des cellules photovoltaïques solides, éventuellement à colorant.

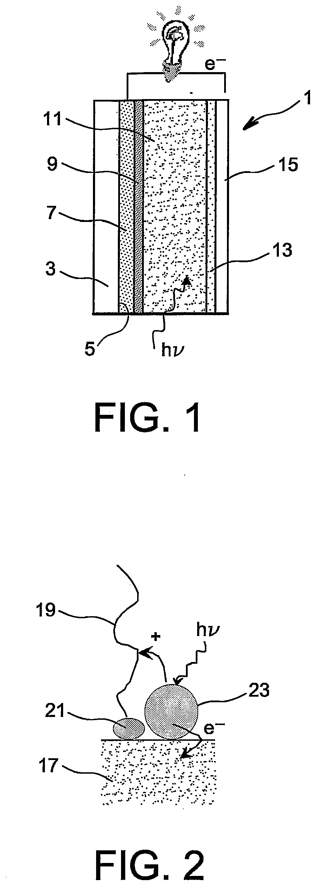

En se référant à la figure 1, on voit une cellule photovoltaïque conforme à la présente invention désignée par la référence générale 1.

La cellule 1 comprend un support 3 transparent en verre recouvert sur une face 5 par une couche conductrice transparente 7, cette couche pouvant être à base d'oxyde d'étain dopé au fluor. Le support revêtu de la couche conductrice transparente fait office d'électrode collectrice de courant (dite première électrode selon la terminologie employée ci-dessus).

Une couche dense de dioxyde de titane 9 est déposée sur la couche conductrice transparente 7. Sur cette couche dense est disposée une couche de matériau semi-conducteur 11, ledit matériau semi-conducteur correspondant au matériau hybride inorganique-organique semi-conducteur P-N de l'invention. Sur cette couche en matériau semi-conducteur 11 est déposée une couche en polymère conducteur 13, sur laquelle est déposée une couche métallique 15, par exemple une couche à base d'or et de nickel. La couche en polymère conducteur 13, prise en sandwich entre la couche en matériau semi-conducteur 11 et la couche métallique 15, permet de limiter les phénomènes de court circuit. La couche métallique 15 fait office de contre-électrode (dite seconde électrode selon la terminologie employée ci-dessus).

La figure 2 représente une partie agrandie de la couche en matériau semi-conducteur 11 et montre plus précisément l'interface entre la surface du substrat en céramique oxyde poreuse et le polymère conducteur de l'électricité et une substance chromophore.

Sur cette figure, la référence 17 désigne une surface de la paroi d'un pore de la céramique oxyde poreuse. Sur cette surface est greffée un polymère conducteur de l'électricité 19 via un composé 21 tel que défini précédemment comportant un groupe permettant le greffage chimique sur la surface de la paroi d'un pore de la céramique oxyde poreuse 17. A proximité de ce polymère conducteur de l'électricité 19, la surface 17 est sensibilisée par une substance chromophore 23 (adsorbée ou greffée à ladite surface). Lorsqu'un rayon lumineux atteint la substance chromophore (ledit rayon lumineux étant représentée par une flèche hv), l'énergie lumineuse qu'il transporte sous forme de photons est absorbée par la substance chromophore. Celle-ci se libère d'un électron e⁻ qui est directement, dans ce cas de figure, capté par la céramique oxyde poreuse, tandis que le trou de charge symbolisé + créé de manière concomittante à l'électron est capté par le polymère conducteur. Il y a ainsi une dissociation de la paire électron-trou sans recombinaison et donc création d'un courant électrique au sein de matériau.

Les cellules photovoltaïques de la présente invention peuvent être préparées de la façon suivante :
- une étape de dépôt sur un support recouvert éventuellement d'une couche conductrice transparente d'un film de céramique oxyde, ledit dépôt pouvant se faire par des techniques sous vide ou par voies humides précédemment décrites, ces deux types de procédés étant à la portée de l'homme du métier ;
- la mise en oeuvre du procédé de préparation du matériau semi-conducteur tel que défini précédemment, de manière à obtenir à partir du film de céramique oxyde susmentionné ledit matériau semi-conducteur;
- éventuellement, une étape de dépôt sur la couche en matériau conducteur d'une couche en polymère conducteur de l'électrité, de préférence, identique à celui constitutif du matériau hybride inorganique-organique semi-conducteur P-N de l'invention, ladite couche étant déposée par des techniques par voie humide précédemment décrites, à la portée de l'homme du métier ;
- une étape de dépôt d'une couche métallique telle que définie précédemment sur la couche en matériau semi-conducteur ou le cas échéant sur la couche en polymère conducteur de l'électricité.

La présente invention va maintenant être décrite par rapport à un exemple de réalisation.

### BRÈVE DESCRIPTION DES DESSINS ET DES SPECTRES

La figure 1 correspond à une vue en coupe d'une cellule photovoltaïque de l'invention, déjà décrite.
La figure 2 correspond à une partie agrandie d'une partie de la cellule représentée sur la figure 1, cette partie étant décrite ci-dessus.
La figure 3 montre le spectre en transmission (représenté en noir) d'une cellule photovoltaïque sans contre-électrode, préparées selon le mode de réalisation proposé ci-après et, à titre d'exemple, le spectre d'émission du soleil (représenté en gris).

L'invention va maintenant être décrite en référence à l'exemple ci-dessous.

### EXPOSÉ DÉTAILLÉ DE MODES DE RÉALISATION PARTICULIERS

### Exemple : Procédé d'élaboration d'un matériau hybride inorganique-organique semi-conducteur P-N pour la réalisation d'une cellule photovoltaïque.

Un substrat de verre de 2x5 cm² recouvert d'une couche conductrice transparente à base de SnO2:F (fabriqué par le firme japonaise ASAHI Glass Corporation) de résistance de surface de l'ordre de 10 Ohm carré et partiellement recouvert d'une fine couche de TiO₂ dense déposée par pulvérisation à chaud est tout d'abord nettoyé à l'aide d'un détergent, puis rincé abondamment à l'eau et séché à l'éthanol.

La couche de matériau hybride inorganique-organique semi-conducteur P-N de l'invention est tout d'abord préparée en déposant sur la couche de TiO₂ dense une couche poreuse de TiO₂ par sérigraphie (ou « screen printing ») à partir de la pâte commercialisée sous le nom de Ti-Nanoxide HT par la société suisse Solaronix. L'ensemble est ensuite densifié à 450°C durant 15 minutes. La couche de la céramique oxyde poreuse de TiO₂ obtenue a une épaisseur de 3 *µ*m. Elle constitue le matériau semi-conducteur de type N du matériau hybride inorganique-organique semi-conducteur P-N.

Le composé comportant un motif thiophène et un groupe carboxylique permettant le greffage chimique avec la surface de la paroi d'un pore de la céramique oxyde poreuse sélectionné est l'acide 3-thiophène acétique (commercialisé par Aldrich sous la référence 22,063-9) suivant :

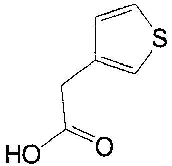

On a choisi comme substance chromophore, le cis-bis (isothiocyanato)bis (2,2'-bipyridyl-4,4'-dicarboxylato)-ruthenium(II) bis-tétrabutylammonium) commerciallisé sous le nom de Ruthénium 535 bis-TBA par la société suisse Solaronix.

Le composé et la substance chromophore sont dissous en proportion équimolaire dans une solution à base d'éthanol.

La céramique oxyde poreuse de TiO₂ est ensuite immergée dans la solution contenant le composé et la substance chromophore durant 24 heures. Ainsi, le composé et la substance chromophore sont greffés à la surface de la paroi d'un pore de la céramique oxyde poreuse de TiO₂ grâce à leurs groupements carboxyliques complexants. La céramique oxyde poreuse ainsi fonctionnalisée est ensuite rincée à l'éthanol.

Après le greffage du composé et de la substance chromophore, le polymère conducteur d'électricité constituant le matériau semi-conducteur P du matériau hybride inorganique-organique semi-conducteur P-N est élaboré de la manière suivante : la couche d'oxyde ainsi fonctionnalisée est immergée dans une solution 0,1 M d'alkylthiophène dans le chloroforme. Une solution 0,3 M de chlorure de fer (FeCl₃) est alors introduite afin d'amorcer la polymérisation. Après 12H à température ambiante, le substrat est rincé au chloroforme puis à l'éthanol. Le substrat est finalement rincé soigneusement au chloroforme afin d'extraire le polymère non gréffé.

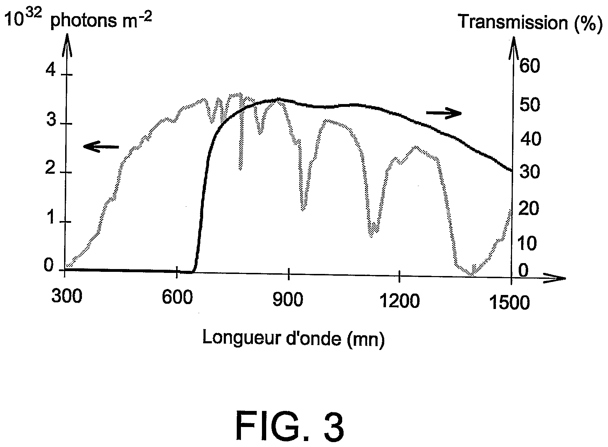

Une couche de polymère conducteur est ensuite déposée sur la couche de matériau hybride inorganique-organique semi-conducteur P-N par enduction centrifuge (connu sous la terminologie anglaise « spin-coating ») à partir d'une solution de polyalkylthiophène à 5% en masse dans le chloroforme. La figure 3 montre le spectre en transmission de l'empilement ainsi préparé.

Une contre-électrode d'or est déposée sur la couche de polymère conducteur par évaporation sous vide.

Sous éclairage de la cellule photovoltaïque ainsi réalisée, on observe un courant électrique entre l'électrode et la contre-électrode : ceci montre que sous forme de couche, le matériau hybride inorganique-organique semi-conducteur P-N permet d'absorber les photons constitutifs de la lumière, de donner naissance à un électron et un trou (on parle de paire électron-trou), de séparer ladite paire à la jonction P-N, de créer une différence de potentiel à la jonction P-N et ainsi de générer un courant électrique entre l'électrode et la contre-électrode.

### Références citées.

[1] WO 93/19479 ;
[2] EP 1 176 646 ;
[3] EP 0 917 208 ;
[4] WO 93/20569.

## Revendications

1. Matériau semi-conducteur P-N susceptible d'être obtenu par un procédé comprenant successivement les étapes suivantes :
- une étape de fonctionnalisation d'un substrat en céramique oxyde poreuse, qui est un substrat en TiO₂, par greffage chimique d'un ou plusieurs composés comprenant au moins un groupe susceptible d'être polymérisé avec un ou plusieurs précurseurs d'un polymère conducteur de l'électricité, le ou lesdits précurseurs étant un alkylthiophène, et comprenant au moins un groupe apte à se greffer chimiquement audit substrat, ledit composé répondant à la formule : 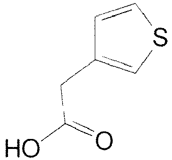
- une étape d'imprégnation dudit substrat ainsi fonctionnalisé par une solution comprenant le ou lesdits précurseur(s) ;
- une étape de polymérisation du ou desdits précurseurs.

2. Procédé de préparation d'un matériau semi-conducteur tel que défini selon la revendication 1, comprenant successivement les étapes suivantes :
- une étape de fonctionnalisation d'un substrat en céramique oxyde poreuse, qui est un substrat en TiO₂, par greffage chimique d'un ou plusieurs composés comprenant au moins un groupe susceptible d'être polymérisé avec un ou plusieurs précurseurs d'un polymère conducteur de l'électricité, le ou lesdits précurseurs étant un alkylthiophène, et comprenant au moins un groupe apte à se greffer chimiquement audit substrat, ledit composé répondant à la formule : 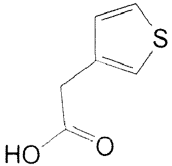
- une étape d'imprégnation dudit substrat ainsi fontionnalisé par une solution comprenant le ou lesdits précurseur(s) ;
- une étape de polymérisation du ou desdits précurseurs.

3. Cellule photovoltaïque comprenant :
- une première électrode collectrice de courant;
- une seconde électrode;
- une zone semi-conductrice constituée d'un matériau tel que défini selon la revendication 1, ladite zone étant disposée entre ladite première électrode et ladite seconde électrode.

## Patentansprüche

1. P-N-Halbleitermaterial, das durch ein Verfahren erhältlich ist, das nacheinander die folgenden Schritte umfasst:
- einen Schritt der Funktionalisierung eines Substrats aus poröser Oxidkeramik, bei dem es sich um ein Substrat aus TiO₂ handelt, durch chemisches Aufpfropfen einer oder mehrerer Verbindungen mit mindestens einer Gruppe, die mit einer oder mehreren Vorstufen eines elektrisch leitenden Polymers polymerisierbar ist, wobei es sich bei der Vorstufe bzw. den Vorstufen um ein Alkylthiophen handelt, und mindestens einer Gruppe, die chemisch auf das Substrat aufgepfropft werden kann, wobei die Verbindung der Formel: 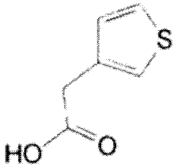 entspricht;
- einen Schritt der Imprägnierung des so funktionalisierten Substrats mit einer Lösung, die die Vorstufe bzw. die Vorstufen umfasst;
- einen Schritt der Polymerisation der Vorstufe bzw. der Vorstufen.

2. Verfahren zur Herstellung eines Halbleitermaterials nach Anspruch 1, das nacheinander die folgenden Schritte umfasst:
- einen Schritt der Funktionalisierung eines Substrats aus poröser Oxidkeramik, bei dem es sich um ein Substrat aus TiO₂ handelt, durch chemisches Aufpfropfen einer oder mehrerer Verbindungen mit mindestens einer Gruppe, die mit einer oder mehreren Vorstufen eines elektrisch leitenden Polymers polymerisierbar ist, wobei es sich bei der Vorstufe bzw. den Vorstufen um ein Alkylthiophen handelt, und mindestens einer Gruppe, die chemisch auf das Substrat aufgepfropft werden kann, wobei die Verbindung der Formel: 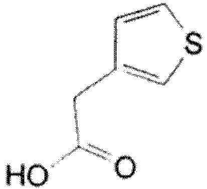 entspricht;
- einen Schritt der Imprägnierung des so funktionalisierten Substrats mit einer Lösung, die die Vorstufe bzw. die Vorstufen umfasst;
- einen Schritt der Polymerisation der Vorstufe bzw. der Vorstufen.

3. Photovoltaikzelle mit:
- einer ersten stromsammelnden Elektrode;
- einer zweiten Elektrode;
- einer halbleitenden Zone, die aus einem Material gemäß Anspruch 1 besteht, wobei die Zone zwischen der ersten Elektrode und der zweiten Elektrode angeordnet ist.

## Claims

1. A pn-semiconductor material that can be obtained by a method comprising in succession the following steps:
- a step in which a substrate made of a porous oxide ceramic, which is a substrate in titanium dioxide TiO₂, is functionalized by chemical grafting of one or more compounds containing at least one group that can be polymerized with one or more precursors of an electrically conducting polymer, the precursor(s) being an alkylthiophene and at least one group able to be chemically grafted onto said substrate, said compound satisfying the following formula: 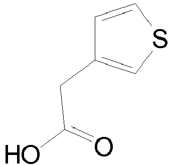
- a step in which said substrate thus functionalized is impregnated with a solution containing said precursor(s); and
- a step in which said precursor or precursors are polymerized.

2. A method of preparing a semiconductor material as defined in claim 1, comprising in succession the following steps:
- a step in which a substrate made of a porous oxide ceramic, which is a substrate in titanium dioxide TiO₂ is functionalized by chemical grafting of one or more compounds containing at least one group that can be polymerized with one or more precursors of an electrically conducting polymer, the precursor(s) being an alkylthiophene, and at least one group able to be chemically grafted onto said substrate, said compound satisfying the following formula: 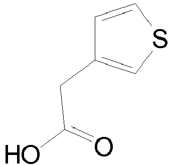
- a step in which said substrate thus functionalized is impregnated with a solution containing said precursor(s); and
- a step in which said precursor or precursors are polymerized.

3. A photovoltaic cell comprising:
- a current-collecting first electrode;
- a second electrode; and
- a semiconducting region consisting of a material as defined in claim 1, said region being placed between said first electrode and said second electrode.
